**Europäisches Patentamt**

**European Patent Office**

**Office européen des brevets**

(19)

(11) Veröffentlichungsnummer: **0 331 789**

**A2**

(12) ## EUROPÄISCHE PATENTANMELDUNG

(21) Anmeldenummer: 88109061.7

(22) Anmeldetag: 07.06.88

(51) Int. Cl.⁴: **G06F 7/48**

(30) Priorität: 26.02.88 DE 3806226

(43) Veröffentlichungstag der Anmeldung:
**13.09.89 Patentblatt 89/37**

(84) Benannte Vertragsstaaten:
**AT BE CH DE FR GB IT LI NL SE** ,

(71) Anmelder: **Siemens Aktiengesellschaft**
**Wittelsbacherplatz 2**
**D-8000 München 2(DE)**

(72) Erfinder: **Hafner, Karlheinz, Dr.rer.nat.**
**Schiessstättstrasse 16**
**D-8000 München 2(DE)**
Erfinder: **Deppermann, Michael, Dipl.-Math.**
**Weidenerstrasse 35**
**D-8000 München 83(DE)**
Erfinder: **Wallstab, Stefan, Dipl.-Ing.**
**Jörgstrasse 23**
**D-8000 München 21(DE)**

(54) **Speicher für eine Rechenanlage, die im Gleitpunktformat oder Festpunktformat dargestellte Zahlen hoch genau verknüpft.**

(57) Bei technisch-wissenschaftlichen Berechnungen mit Gleitpunktzahlen auf Computern kann es durch Akkumulation von Rundungsfehlern zu Verfälschungen der Resultate kommen. Durch Umwandlung der Gleitpunktzahlen in Festpunktzahlen und anschließende Ausführung der arithmetischen Operationen im Festpunktformat können diese Rundungsfehler vermieden werden. Das Rechenwerk in der Rechenanlage verarbeitet dann die Festpunktzahlen. Dazu ist erforderlich, daß die Festpunktzahlen in den Registern, auf die das Rechenwerk zugreift, lagerichtig angeordnet sind. Bei einem umfangreichen Gleitpunktformat führt dies zu einem entsprechend großen Festpunktformat und damit zu einem entsprechend großen Register. Um bei einer Rechenanlage, die derartige Gleitpunktzahlen verarbeitet, einen Multiuserbetrieb oder einen Multitaskbetrieb zu ermöglichen, ist ein Speicher (SP) vorgesehen, der in Abschnitte (AB) gleicher Länge aufgeteilt ist. Jeder Abschnitt (AB) ist weiterhin in Segmente (SG) gleicher Länge unterteilt. Jeder Abschitt hat eine solche Länge, daß eine Festpunktzahl im Langformat gespeichert werden kann. Zusätzlich können in einem Segment (SG0) des Abschnittes Verwaltungsdaten gespeichert werden, die angeben, in welchem Bereich der Festpunktzahl im Langformat die zu verarbeitenden Daten enthalten sind. In den Segmenten der Abschnitte können weiterhin Gleitpunktzahlen gespeichert werden. Die Zuweisung der Abschnitte zu Festpunktzahlen und Gleitpunktzahlen ist variabel und kann den einzelnen auszuführenden Aufgaben angepaßt werden. Das Rechenwerk der Rechenanlage kann mit den verschiedenen Abschnitten des Speicher zusamenarbeiten, wodurch ein Multiuserbetrieb oder Multitaskbetrieb möglich ist. Jedes der Abschnitte des Speichers kann somit in der Funktion eines Akkumulators verwendet werden.

FIG 2

Xerox Copy Centre

**Speicher für eine Rechenanlage, die im Gleitpunktformat oder Festpunktformat dargestellte Zahlen hochgenau verknüpft**

Die Erfindung bezieht sich auf einen Speicher für eine Rechenanlage, die im Gleitpunktformat oder Festpunktformat dargestellte Zahlen hochgenau arithmetisch verknüpft.

Bei umfangreichen technisch-wissenschaftlichen Berechnungen mit Gleitpunktzahlen auf Computern kann die Akkumulation von Rundungsfehlern zu Verfälschungen der Resultate führen. Durch Konvertierung der Gleitpunktzahlen in Festpunktzahlen und anschließende Ausführung der arithmetischen Grundoperationen im Festpunktformat können Rundungsfehler bei Addition, Substraktion und Multplikation vollständig vermieden werden. Wird erst am Ende einer Folge von solchen Rechenschritten in das Gleitpunktformat zurückgewandelt, dann sind maximal genaue Resultate auch bei komplexen Gleitpunktoperationen wie Summen oder Skalarproduktbildung erzielbar.

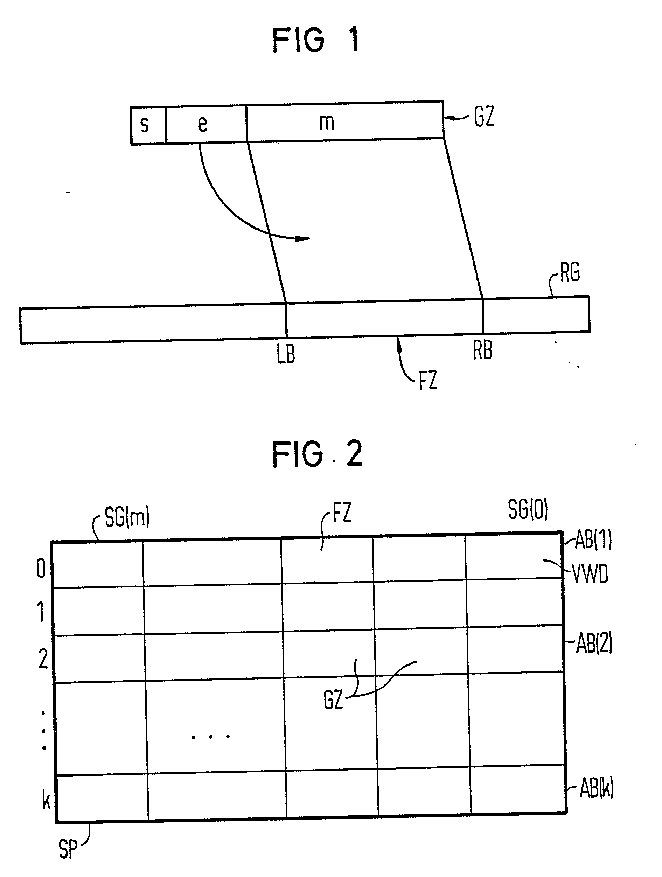

Im verwendeten Festpunktformat müssen alle möglichen Gleitpunktzahlen exakt darstellbar sein, was je nach zugrundegelegtem Gleitpunktformat u.U. ein Festpunktformat mit mehreren 1000 Stellen erforderlich macht. Aus Fig. 1 kann das Verhältnis von Gleitpunktformat zu Festpunktformat schematisch entnommen werden. Es ist eine Gleitpunktzahl GZ dargestellt, die einen Abschnitt für das Vorzeichen s, einen Abschnitt für die Charakteristik e und einen Abschnitt für die Mantisse m enthält. Wenn diese Gleitpunktzahl GZ in eine Festpunktzahl umgewandelt wird, dann gibt die Mantisse m die Ziffernfolge an; die Lage der Mantisse in einem Register RG wird durch die Charakteristik e festgelegt. Sollen Gleitpunktzahlen GZ aus einem großen Wertebereich verarbeitet werden, dann muß das Register RG eine große Breite haben, von z.B. mehreren 1000 Bit. Nur dann ist es möglich, alle von den Gleitpunktzahlen abgeleiteten Festpunktzahlen lagerichtig im Register RG zu speichern. Eine bestimmte Festpunktzahl FZ benötigt also nur einen bestimmten Bereich im Register RG, der in Fig. 1 zwischen LB und RB liegt. Bei der Verknüpfung der Festpunktzahlen wird immer nur der aktuelle Bereich übertragen und bearbeitet. Da aber a priori nicht bekannt ist, welche Bereiche des Registers im Verlauf der Rechnungen belegt werden, kann in jedem Register RG jeweils nur eine Festpunktzahl FZ gespeichert werden. Der Inhalt des Registers RG wird im folgenden als Festpunktzahl im Langformat bezeichnet.

Die Formatkonvertierungen und elementaren arithmetischen Festpunktoperationen können in Software ausgeführt werden, aus Effizienzgründen sollten sie aber durch spezielle Hardwaremaßnahmen unterstützt werden. Es gibt verschiedene Vorschläge zur Hardwareunterstützung dieser hoch präzisen Arithmethik; Beispiele ergeben sich aus EP-PS 0079471, DE 31 44 015 A1 unter Berücksichtigung der dort angegebenen Literatur, in der die Grundzüge der hochgenauen Arithmetik dargestellt sind. In den Schriften ist die Wirkungsweise, der Aufbau und die Organisation von Rechenwerken dargestellt, die elementare arithmetische Operationen mit Festpunktzahlen im Langformat bzw. gemischte Operationen mit Festpunktzahlen im Langformat und Gleitpunktzahlen ausführen. Bei diesen Lösungsvorschlägen wird jeweils nur eine einzige Festpunktzahl im Langformat verwendet, die ganz oder zumindest zum großen Teil in einem Register gespeichert ist. Dieses Register ist üblicherweise eng mit dem Rechenwerk gekoppelt. Bei einem Wechsel der aktuellen Festpunktzahl im Langformat muß jeweils das gesamte lange Register mit einer anderen Festpunktzahl im Langformat aus einem Hintergrundspeicher ausgetauscht werden.

Die der Erfindung zugrundeliegende Aufgabe besteht darin, einen Speicher anzugeben, der zur effizienten Speicherung von Gleitpunktzahlen, Festpunktzahlen im Langformat und eventuell zusätzlich benötigten Verwaltungsdaten geeignet ist. Dabei sollen die Anforderungen eines Multitasking- und Multiuserbetriebes berücksichtigt werden.

Diese Aufgabe wird gemäß den Merkmalen des Patentanspruches 1 gelöst.

Durch eine derartige Gliederung des Speichers wird es ermöglicht, daß pro Abschnitt des Speichers eine Festpunktzahl im Langformat speicherbar ist, wobei zusätzlich die, die Eigenschaften dieser Festpunktzahl kennzeichnenden Verwaltungsdaten ebenfalls im Abschnitt enthalten sind. Es ist aber auch möglich, in die Abschnitte Gleitpunktzahlen zu speichern, wobei die Länge der einzelnen Segmente derart sein kann, daß in ein Segment jeweils mindestens eine Gleitpunktzahl speicherbar ist. Die Gliederung des Speichers hat also den Vorteil, daß derselbe Speicher sowohl zur Speicherung der Festpunktzahlen im Langformat als auch der Gleitpunktzahlen verwendbar ist. Das Rechenwerk kann je nach Aufgabenstellung die einzelnen Abschnitte des Speichers jeweils als Akkumulator verwenden, so daß eine Mehrzahl von Festpunktzahlen im Langformat oder Gleitkommazahlen der Rechenanlage zur Verfügung stehen. Damit ist es auch möglich, daß die Rechenanlage mehrere Benutzer simultan bedient bzw. mehrere Aufgaben simultan bearbeitet.

Die Verwaltungsdaten für die Festpunktzahl können die Werte für LB und RB angeben, die den Bereich festlegen, in dem die nicht trivialen Teile der Festpunktzahl enthalten sind. Zusätzlich kann in den Verwaltungsdaten noch ange geben werden, ob die Festpunktzahl 0 ist und ob die Festpunktzahl positiv oder negativ ist. Für die Speicherung dieser Verwaltungsdaten pro Festpunktzahl kann ein Segment eines Speicherabschnittes genügen.

Die Zuordnung der Abschnitte des Speichers zu den Zahlen, also ob ein Abschnitt zur Speicherung einer Festpunktzahl oder von Gleitpunktzahlen verwendet wird, kann mit Hilfe von Befehlen erfolgen. Dies hat den Vorteil, daß je nach Benutzer die Zuordnung des Speichers zu Festpunktzahl und Gleitpunktzahl festlegbar ist.

Wenn der gewählte Speicher zu groß ist, um zusammen mit dem Rechenwerk und den sonstigen Einheiten einer Rechenanlage auf einem Chip realisiert zu werden, dann ist es zweckmäßig, den Speicher in einen Cachespeicher und einen Hintergrundspeicher aufzuteilen. In diesem Fall sind im Hintergrundspeicher die Festpunktzahlen im Langformat plus deren Verwaltungsdaten und Gleitpunktzahlen gespeichert. Im Cachespeicher dagegen befinden sich nur die akutellen Teile der Festpunktzahlen bzw. der Gleitpunktzahlen.

Anhand eines Ausführungsbeispiels wird die Erfindung weiter erläutert. Es zeigen

Fig. 2 den logischen Aufbau des Speichers,

Fig. 3 eine physikalische Speicherhierarchie des Speichers,

Fig. 4 ein Blockschaltbild der Rechenanlage.

Aus Fig. 2 kann der logische Aufbau des Speichers SP entnommen werden. Der Speicher SP ist in Abschnitte AB1 bis ABK aufgeteilt, die alle gleichlang sind. Die Abschnitte AB sind wiederum unterteilt und zwar in Segmente SG(0) bis SG(m). Die Länge der Abschnitte AB ist durch die Festpunkt zahl im Langformat festgelegt, die durch Verwaltungsdaten VWD ergänzt wird. Für die Verwaltungsdaten VWD genügt dabei ein Segment, z.B. das Segment SG(0). Die übrigen Segmente SG(1) bis SG(m) sind dann für die Festpunktzahl FZ im Langformat verwendbar. Im Ausführungsbeispiel der Fig. 2 ist im Speicherabschnitt AB(1) eine Festpunktzahl FZ gespeichert.

Im Speicher SP können aber auch Gleitpunktzahlen GZ gespeichert sein, wie dies z.B. im Abschnitt AB(2) gezeigt ist. Dabei kann ein Segment eine Gleitpunktzahl enthalten. Verwaltungsdaten sind für Gleitpunktzahlen nicht erforderlich.

Durch Aufteilung der Speicherabschnitte AB in Segmente SG kann der Inhalt der Abschnitte AB segmentweise übertragen werden. Dementsprechend sind die einzelnen Segmente der Abschnitte AB einzeln adressierbar. Der Vorteil dieser Segmentierung beruht darauf, daß nur die aktuellen Teile der Festpunktzahlen übertragen und verarbeitet werden müssen.

In den Segmenten SG der Abschnitte AB können somit Teile einer Festpunktzahl FZ oder Gleitpunktzahlen GZ enthalten sein. Die Zuordnung der Segmente zu der Festpunktzahl bzw. Gleitpunktzahl erfolgt über Befehle, die die Segmente ansprechen. Damit ist es möglich, in Abhängigkeit der zu bearbeitenden Aufgaben die Einzelabschnitte zur Speicherung von Festpunktzahlen oder zur Speicherung von Gleitpunktzahlen zu verwenden. Es ist weiterhin möglich, die verschiedenen Abschnitte AB verschiedenen Aufgaben oder verschiedenen Benutzern zu zuordnen, also in den einzelnen Abschnitten AB z.B. Festpunktzahlen im Langformat für verschiedene Benutzer oder verschiedene Aufgaben zu speichern.

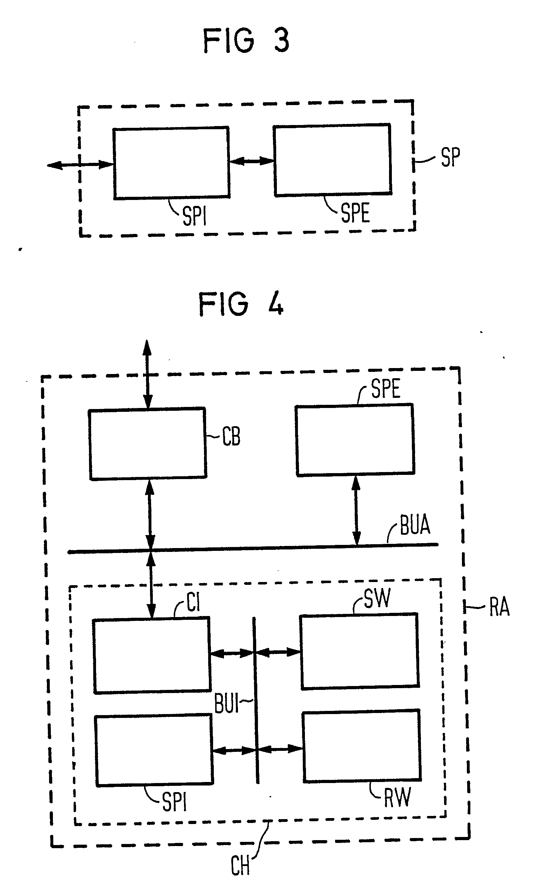

Sollte der Speicher zu groß sein, um zusammen mit anderen Einheiten des Rechners auf einem Chip angeordnet werden zu können, dann ist es zweckmäßig, entsprechend Fig. 3 den Speicher SP in einen internen, auf dem Chip CH realisierten Speicher und einen externen, außerhalb des Chips realisierten Speicher aufzuteilen. Der interne Speicher ist in Fig. 3 mit SPI, der externe Speicher mit SPE bezeichnet. Dabei kann der interne Speicher SPI als Cachespeicher eingesetzt werden, der je nach Bedarf auf den externen Speicher, den Hintergrundspeicher, zurückgreift. Der interne Speicher nimmt dann nur einen Bruchteil der insgesamt adressierbaren Segmente auf. Alle zu speichernden Festpunktzahlen und Gleitpunktzahlen stehen dagegen im Hintergrundspeicher SPE. Im externen Speicher SPE sind dabei die Festpunktzahl im Langformat gespeichert zusammen mit ihren Verwaltungsdaten, während im internen Speicher SPI nur die Teile der Festpunktzahlen enthalten sind, die gerade zur Bearbeitung benötigt werden. Diese Teile werden aktuelle Teile genannt.

Eine Speicherhierarchie gemäß Fig. 3 ist bekannt und braucht darum nicht ausführlich erläutert werden. Der Austausch der Inhalte der Segmente zwischen internem und externem Speicher kann sowohl durch Befehle als auch durch einen hardwaremäßig verankerten Austauschalgorithmus gesteuert werden. Der Zugriff zu einem Segment erfolgt dabei folgendermaßen: Signalisiert das Rechenwerk einen lesenden oder schreibenden Segmentzugriff, dann wird zuerst geprüft, ob sich das verlangte Segment bereits im internen Speicher SPI befindet. Ist dies der Fall, dann kann die Anfrage sofort bedient werden. Befindet sich das verlangte Segment nicht im internen Speicher SPI, dann muß es erst vom externen Speicher SPE nachgeladen werden. Dies erfordert zusätzliche Verarbeitungs schritte, insbesondere bei voll belegtem internen Speicher SPI auch die Verdrängung eines anderen Segments nach einer der üblichen Strategien, wie z.B. FIFO, LRU usw.. Vom externen Speicher SPE werden nur die Teile einer Festpunktzahl übertragen, die zur Verknüpfung benötigt werden. Diese sind in der Regel die innerhalb der Grenzen LB und RB befindlichen Teile der Festpunktzahl im Langformat.

Ein Beispiel einer Rechenanlage RA kann der Fig. 4 entnommen werden. Die Rechenanlage enthält ein Rechenwerk RW, ein Steuerwerk SW, den internen Speicher SPI und ein Interface CI. Zusätzlich sind noch der externe Speicher SPE und ein Interface CB vorgesehen. Im Ausführungsbeispiel sind die Einheiten SW, RW, SPI und CI auf einem Chip CH angeordnet, die Einheiten SPE und CB dagegen außerhalb dieses Chips. Die Chipgrenze ist gepunktet dargestellt, die Baugruppengrenze gestrichelt. Die einzelnen Einheiten sind über Busse BUA und BUI miteinander verbunden.

Der Aufbau des internen Speichers SPI und des externen Speichers SPE ist bereits oben erläutert worden. Die übrigen Einheiten der Rechenanlage können in bekannter Weise aufgebaut sein. Ein Ausführungsbeispiel für das Rechenwerk kann z.B. der DE 31 44 015 A1 entnommen werden. Eine Realisierung des Steuerwerkes SW kann z.B. "Introduction to VLSI Systems" von Carver Mead und Lynn Conway, Okt. 1980, Addison-Wesley Publishing Comp. entnommen werden. Dort ist dargestellt, wie ein Steuerwerk SW entwickelt wird (vgl. Seite 200 f). Ein Interface ist ab Seite 164 erläutert.

**Ansprüche**

1. Speicher für eine Rechenanlage, die im Gleitpunktformat oder Festpunktformat dargestellte Zahlen hochgenau verknüpft mit folgenden Merkmalen:
es sind Abschnitte (AB) gleicher Länge vorgesehen, die jeweils in Segmente gleicher Länge unterteilt sind, die Länge jedes Abschnittes (AB) ist derart, daß jede von einer Gleitpunktzahl abgeleitete Festpunktzahl im Langformat und Eigenschaften dieser Festpunktzahl kennzeichnende Verwaltungsdaten in einem Abschnitt speicherbar sind,
jeder Abschnitt (AB) und jedes Segment (SG) ist adressierbar.

2. Speicher nach Anspruch 1, dadurch **gekennzeichnet,** daß in den Abschnitten (AB) sowohl Festpunktzahlen (FP) als auch Gleitpunktzahlen (GZ) speicherbar sind.

3. Speicher nach Anspruch 1 oder 2, dadurch **gekennzeichnet,** daß pro Abschnitt (AB) eine Festpunktzahl im Langformat mit ihren Verwaltungsdaten (VWD) speicherbar ist, und daß für die Verwaltungsdaten ein Segment (SG(0)) vorgesehen ist.

4. Speicher nach Anspruch 3, dadurch **gekennzeichnet,** daß die Verwaltungsdaten angeben, welcher Teil des zugeordneten Abschnittes die nicht trivialen Teile der Festpunktzahl enthält und ob die Festpunktzahl positiv/negativ oder 0 ist.

5. Speicher nach einem der vorhergehenden Ansprüche, dadurch **gekennzeichnet,** daß die Zuordnung der Abschnitte und deren Segmente zu den Zahlen über Befehle erfolgt.

6. Speicher nach einem der vorhergehenden Ansprüche, dadurch **gekennzeichnet,** daß ein Cachespeicher (SPI) und ein Hintergrundspeicher (SPE) vorgesehen ist, daß im Hintergrundspeicher (SPE) die Festpunktzahlen im Langformat plus deren Verwaltungsdaten und Gleitpunktzahlen gespeichert sind, und daß im Cachespeicher (SPI) die aktuellen Teile von Festpunktzahlen bzw. Gleitpunktzahlen gespeichert sind.

# FIG 1

| s | e | m | ← GZ |

LB

RG

RB

FZ

# FIG . 2

SG(m)    FZ    SG(0)

AB(1)

VWD

0

1

2

·
·
·

. . .

GZ

k

SP

AB(2)

AB(k)

# FIG 3

# FIG 4